**Europäisches Patentamt**

**European Patent Office**

**Office européen des brevets**

(19)

(11) Veröffentlichungsnummer: **0 311 702 B1**

## EUROPÄISCHE PATENTSCHRIFT

(12)

(45) Veröffentlichungstag der Patentschrift: **20.05.92**

(51) Int. Cl.⁵: **H05K 7/20**

(21) Anmeldenummer: **87115000.9**

(22) Anmeldetag: **14.10.87**

(54) **Einschubgehäuse.**

(43) Veröffentlichungstag der Anmeldung:
**19.04.89 Patentblatt 89/16**

(45) Bekanntmachung des Hinweises auf die
Patenterteilung:
**20.05.92 Patentblatt 92/21**

(84) Benannte Vertragsstaaten:
**AT BE CH DE ES FR GB GR IT LI LU NL SE**

(56) Entgegenhaltungen:
**EP-A- 0 236 501**
**DE-A- 2 211 268**
**DE-A- 3 316 978**

(73) Patentinhaber: **Schroff GmbH**
**Industriegebiet**
**W-7541 Straubenhardt 1(DE)**

(72) Erfinder: **Mazura, Paul**
**Turmbergstrasse 22**
**W-7516 Karlsbad/Spielberg(DE)**

(74) Vertreter: **Durm, Klaus, Dr.-Ing. et al**
**Patentanwälte Dr.-Ing. Klaus Durm Dipl.-Ing.**
**Frank Durm Felix-Mottl-Strasse 1a**
**W-7500 Karlsruhe 21(DE)**

## Beschreibung

Die Erfindung betrifft ein Einschubgehäuse für elektrische und elektronische Geräte zum Einschieben in Gestelle und Schränke eines zumindest bezüglich der Höheneinheiten genormten Aufbausystems, mit einem aus Profilschienen und Seitenwänden zusammengesetzten Baugruppenträger sowie einem mehrteiligen Mantel mit wenigstens einer Zuluftöffnung und wenigstens einer Abluftöffnung; siehe z.B. DE-A-2211268.

Das vorgeschlagene Einbaugehäuse kann als unabhängiges Tischgerät verwendet werden, und es findet insbesondere dann Anwendung, wenn es sich bei Bedarf als passender Einschub in einen nach dem 19-Zoll-Aufbausystem genormten Geräteschrank integrieren lassen soll.

Die Abfuhr der Verlustwärme der in den Baugruppenträgern angeordneten elektrischen Bauelemente geschieht durch Konvektion; hierzu weisen die Gehäuse Lüftungsöffnungen auf, welche im Gehäuseboden und in der Gehäusedecke angebracht sind. Solange ein derartiges Gehäuse als Tischgehäuse benutzt wird, reicht die entstehende Luftströmung in der Regel aus, die Bauteile ausreichend zu kühlen. Wird nun dieses Gehäuse in einen Schrank oder ein Gestell eingeschoben, in welchem direkt darüber und unterhalb weitere Einschübe eingesetzt sind, dann wird infolge der Verdeckung der Lüftungsöffnungen die Konvektion so stark behindert, daß mit Hilfe von Lüftern eine Kühlluftstrom erzeugt werden muß, welcher die Baugruppen durchströmt und die nötige Wärmeabfuhr bewirkt. Für die Kühllufterzeugung sind Axiallüfter, Querstromgebläse und Radiallüfter bekannt, welche - oft zu mehreren zusammengefaßt - in gesonderten Lüftereinschüben eingebaut sind. Diese Lüftereinschübe nehmen in den Geräteschränken nicht wenig Platz in Anspruch, ihre Höhe beträgt in genormten Systemen mindestens eine Höheneinheit, welche für andere Einschübe verlorengeht. Entsprechendes gilt für Luftleitbleche bei zentralbelüfteten Geräteschränken.

Der Erfindung liegt die Aufgabe zugrunde, ein Einschubgehäuse für elektrische und elektronische Geräte zum Einschub in Schränke eines genormten Aufbausystems so auszubilden, daß sein Platzbedarf verringert und Lüftereinschübe erübrigt werden können.

Zur Lösung der gestellten Aufgabe wird von einem Einschubgehäuse mit einem aus Profilschienen und Seitenwänden zusammengesetzten Baugruppenträger sowie einem mehrteiligen Mantel mit wenigstens einer Zuluftöffnung und wenigstens einer Abluftöffnung ausgegangen. Gelöst wird die Aufgabe dadurch, daß der Mantel eine Höheneinheit höher ist als der mehrere Höheneinheiten hohe Baugruppenträger, daß der Baugruppenträger zur Bildung eines am Gehäuseboden angeordneten, horizontalen, seitlich nach oben offenen Zuluftschachtes einen unteren Abstand vom Mantel aufweist und zur Bildung eines an der Gehäusedecke angeordneten, horizontalen, seitlich nach unten offenen Abluftschachtes einen oberen Abstand vom Mantel aufweist, wobei der untere Abstand und der obere Abstand zusammen eine Höheneinheit betragen, daß der Mantel wenigstens eine frontseitige Zuluftöffnung trägt, an welcher der Zuluftschacht angeschlossen ist, und daß die Abluftöffnung im oberen Bereich der Gehäuserückwand vorgesehen ist und an den Abluftschacht anschließt. Dieses Einschubgehäuse benötigt für die Belüftung lediglich eine Höheneinheit und es läßt sich ohne besondere Maßnahmen sowohl als Tischgehäuse wie als Einschub in Geräteschränke verwenden.

Zweckmäßig beträgt der untere Abstand und der obere Abstand jeweils eine halbe Höheneinheit; zur Verbesserung der Strömungsverhältnisse kann jedoch der untere Abstand auch ein Drittel und der obere Abstand zwei Drittel einer Höheneinheit betragen.

Zum Zwecke einer besseren Luftführung kann der Baugruppenträger eine Rückwand aufweisen, die an den rückwärtigen Profilschienen befestigt ist.

Zur rückwärtigen Begrenzung des Zuluftschachtes ist zweckmäßig in diesem zwischen dem Gehäuseboden des Mantels und dem Baugruppenträger ein Leitblech vorgesehen.

Während der Zuluftschacht zweckmäßig durch den offenen Gehäuseboden, die beiden Seitenwände sowie die offene Unterseite des Baugruppenträgers gebildet wird, wird der Abluftschacht durch die Gehäusedecke, die beiden Seitenwände sowie die offene Oberseite des Baugruppenträgers gebildet.

Nach einem weiteren Merkmal der Erfindung weist der Mantel einen rechteckigen Frontrahmen auf, an welchem der Baugruppenträger befestigt ist. Dieser Frontrahmen dient als Bindeglied zwischen dem mehrteiligen Mantel und dem Baugruppenträger und er gestattet auf einfache Weise die Befestigung von Haltegriffen oder von Haltewinkeln.

Vorteilhaft ist die Zuluftöffnung an der unteren Stirnkante des Frontrahmens angeordnet. Diese Maßnahme läßt die Zuluft ungehindert in den Zuluftschacht auch bei in Geräteschränke eingeschobenem Gehäuse eintreten.

Die Zuluftöffnung kann durch eine Reihe von parallelen Schlitzen gebildet sein.

Zur Vergrößerung des wirksamen Querschnittes der Schlitze können diese in eine Schräge des Frontrahmens eingelassen sein.

Es ist von Vorteil, wenn die Seitenwände des Baugruppenträgers rückwärtige Verlängerungen aufweisen und der Baugruppenträger zwei mit den Profilschienen parallele Halteschienen besitzt, welche an den Verlängerungen befestigt sind.

Zwischen den Halteschienen können ein oder mehrere Lüfter angeordnet sein.

Nach einem weiteren Merkmal der Erfindung sind an den Seitenwänden des Baugruppenträgers obere und untere Seitenleisten angeformt, welche verschiedene Befestigungsvorrichtungen tragen.

Zweckmäßig ist der Frontrahmen an den Befestigungsvorrichtungen befestigt.

Die Erfindung wird nachstehend an Hand der beigefügten Zeichnungen näher erläutert. In diesen Zeichnungen zeigen

Fig. 1    ein drei Höheneinheiten einnehmendes Einschubgehäuse in einem Längsschnitt, in vereinfachter Darstellung;

Fig. 2    einen Schrank eines Aufbausystems mit verschiedenen Einschüben sowie zwei Einschubgehäusen gemäß Figur 1, in einem Vertikalschnitt, schematisch wiedergegeben.

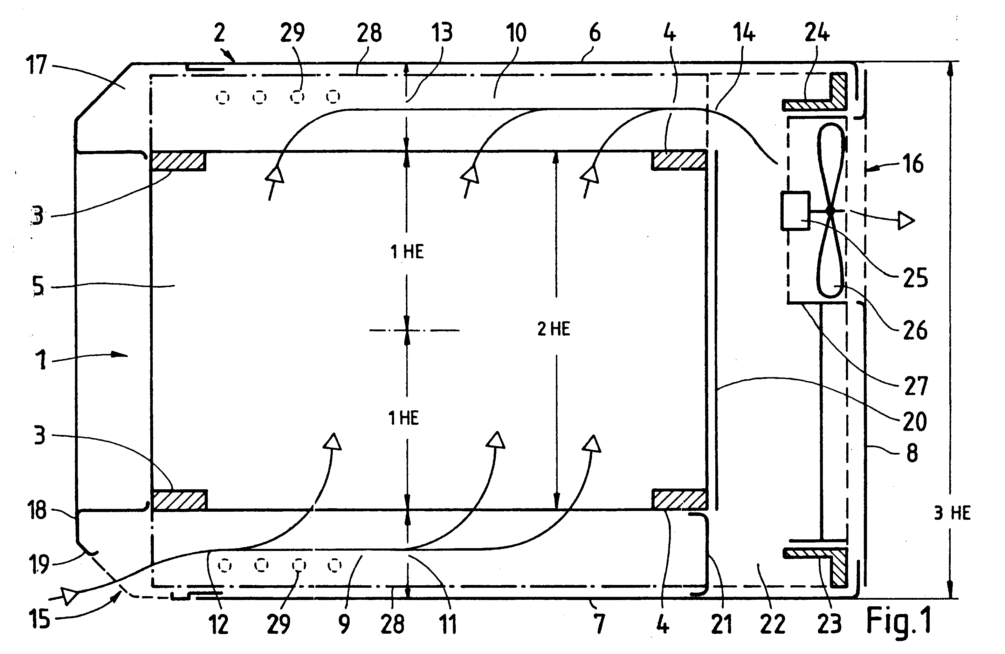

Das in Figur 1 stark vereinfacht dargestellte Einschubgehäuse besteht im wesentlichen aus einem Baugruppenträger 1 und einem Mantel 2. Dieser Mantel 2 umkleidet den Baugruppenträger 1.

Der prismatische Baugruppenträger 1 ist aus zwei vorderen Profilschienen 3 und zwei rückwärtigen Profilschienen 4 sowie zwei Seitenwänden 5 zusammengesetzt. Die Profilschienen 3 und 4 stehen parallel zueinander, und die Seitenwände liegen rechtwinklig zu den Profilschienen 3 und 4. Alle Teile des Baugruppenträgers 1 und des Mantels 2 bestehen aus Aluminium bzw. Stahlblech. Die Seitenwände 5 und die Profilschienen 3 und 4 sind miteinander verschraubt.

Der Mantel 2 ist mehrteilig und besteht aus einer Gehäusedecke 6, einem Gehäuseboden 7 und einer Gehäuserückwand 8.

Das für elektronische und/oder elektrische Geräte vorgesehene Einschubgehäuse ist zum Einschieben in Schränke bzw. Gestelle eines Aufbausystems vorgesehen, welches wenigstens hinsichtlich seiner Höheneinheiten HE genormt ist. Bei dem weit verbreiteten "19-Zoll-Aufbausystem" beträgt diese Höheneinheit 44,45 Millimeter. Der Baugruppenträger 1 des dargestellten Einschubgehäuses nimmt zwei Höheneinheiten HE ein, und der Mantel 2 ist um genau eine Höheneinheit HE höher, letzterer ist somit 3 HE hoch.

Zwischen dem Baugruppenträger 1 und dem Mantel 2 sind ein Zuluftschacht 9 und ein Abluftschacht 10 vorgesehen, welche der Bewerkstelligung der Kühlung der im Baugruppenträger 1 untergebrachten Baugruppen dienen.

Zur Bildung des am Gehäuseboden 7 angeordneten, horizontal und unterhalb des Baugruppenträgers 1 liegenden Zuluftschachtes 9 weist der Baugruppenträger 1 einen unteren Abstand 11 vom Mantel bzw. von dessen Gehäuseboden 7 auf. Dieser Zuluftschacht 9 ist an seiner Seite nach oben zum Baugruppenträger 1 hin offen, damit die Zuluft 12 (vgl. die Pfeile) von unten her zu den Baugruppen des Baugruppenträgers 1 gelangen kann. Entsprechend weist der Baugruppenträger 1 einen oberen Abstand 3 vom Mantel 2 bzw. von dessen Gehäusedecke 6 auf, durch welchen der seitlich nach unten zum Baugruppenträger 1 hin offene Abluftschacht 10 gebildet wird, damit die Abluft 14 abgeführt (vgl. die Pfeile) werden kann. Der untere Abstand 11 und der obere Abstand 12 sind gleich hoch und sie betragen jeweils eine halbe Höheneinheit HE; beide Abstände 11 und 12 zusammen nehmen somit nur eine ganze Höheneinheit HE in Anspruch.

Der Zuluftschacht 9 ist begrenzt durch den Gehäuseboden 7, die beiden Seitenwände 5 des Baugruppenträgers 1 sowie durch die offene Unterseite des Baugruppenträgers 1, während der Abluftschacht 10 durch die Gehäusedecke, die beiden Seitenwände 5 und die offene Oberseite des Baugruppenträgers 1 begrenzt ist.

Der Mantel 2 besitzt eine vordere Zuluftöffnung 15, an diese ist der Zuluftschacht 9 angeschlossen. Eine sich an den Abluftschacht 10 anschließende Abluftöffnung 16 ist in dem oberen Bereich der Gehäuserückwand 8 vorgesehen, die an der Gehäusedecke 6 und am Gehäuseboden 7 angrenzt.

Der Mantel 2 des Einschubgehäuses weist einen rechteckigen, aus mehreren Teilen zusammengesetzten Frontrahmen 17 aus Druckguß auf, an welchem der Baugruppenträger 1 mit seinen beiden Seitenwänden 5 befestigt ist. Die Zuluftöffnung 15 in Gestalt einer Reihe von Schlitzen ist längs der unteren Stirnkante 18 des Frontrahmens 17 in einer Schräge 19 angeordnet. An den Frontrahmen 17 können seitlich (nicht dargestellte) Haltewinkel angeschraubt werden, mit deren Hilfe das Einschubgehäuse im Geräteschrank befestigbar ist.

Der Baugruppenträger 1 weist eine Rückwand 20 auf, welche etwa durch eine Busplatine gebildet sein kann. Diese Rückwand 20 ist an den rückwärtigen Profilschienen 4 angeschraubt, sie schließt die Rückseite des Baugruppenträgers 1 ab und dient der Führung der Zuluft 12 durch die im Baugruppenträger 1 angeordneten Baugruppen nach oben in Richtung zur Gehäusedecke 6.

Ein Leitblech 21 ist im Zuluftschacht 9 zwischen dem Gehäuseboden 7 des Mantels 2 und dem Baugruppenträger 1 angeordnet, dieses Leitblech 21 ist an der rückwärtigen, unteren Profilschiene 4 angeschraubt, und es schließt den Zuluftschacht 9 rückwärts ab.

Die Seitenwände 5 des Baugruppenträgers 1 weisen rechteckige, rückwärtige Verlängerungen 22 auf, wie dies in Figur 1 mit Strichlinien angedeutet ist. Diese Verlängerungen 22 sind mit den Seitenwänden 5 einstückig hergestellt, fluchten mit diesen und sie erstrecken sich bis zur Gehäuserückwand 8 des Mantels 2. An den Verlängerungen 22 sind rechtwinklig und parallel zu den Profilschienen 3 bzw. 4 zwei im Profil L-förmige Halteschienen 23 und 24 befestigt.

Zwischen den beiden Halteschienen 23 und 24 ist ein mit einem Elektromotor 25 angetriebener Lüfter 26 angeordnet, welcher vor der Abluftöffnung 16 steht. Das Lüfterrad dreht sich in einem kreisförmigen Leitring 27.

An den Seitenwänden 5 des Baugruppenträgers 1 sind obere und untere, länglich-rechteckige Seitenleisten 28 in der gleichen Ebene angeformt, welche in Figur 1 mit strichpunktierten Linien verdeutlicht sind. An diesen Seitenleisten 28 sind Befestigungsvorrichtungen 29 in Gestalt von Lochreihen o.ä. vorgesehen, an welchen der Frontrahmen 17 angeschraubt ist.

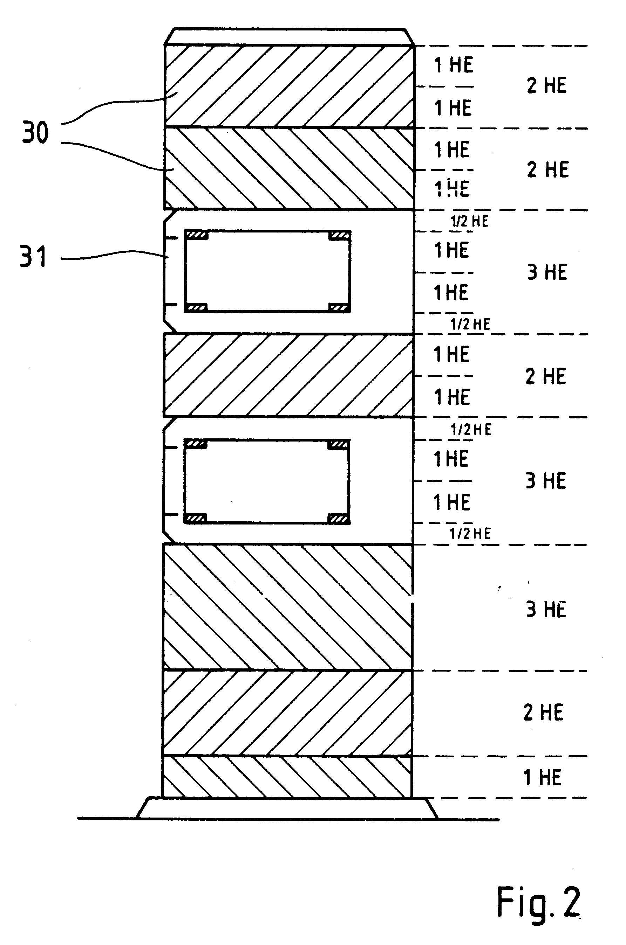

In dem mit Figur 2 vereinfacht wiedergegebenen Geräteschrank eines 19-Zoll-Aufbausystems sind neben verschiedenen, Baugruppen tragenden Einschüben 30 mit Höhen zwischen ein und drei Höheneinheiten HE zwei Einschubgehäuse 31 untergebracht, welche demjenigen nach Figur 1 entsprechen und die den Platz von drei Höheneinheiten HE einnehmen.

Zusammenstellung der verwendeten Bezugsziffern

| | |
|---|---|
| 1 | Baugruppenträger |
| 2 | Mantel |
| 3 | Profilschienen, vordere |
| 4 | Profilschienen, rückwärtige |
| 5 | Seitenwände |
| 6 | Gehäusedecke |
| 7 | Gehäuseboden |
| 8 | Gehäuserückwand |
| HE | Höheneinheit |
| 9 | Zuluftschacht |
| 10 | Abluftschacht |
| 11 | Abstand (unterer) |
| 12 | Zuluft |
| 13 | Abstand (oberer) |
| 14 | Abluft |
| 15 | Zuluftöffnung |
| 16 | Abluftöffnung |
| 17 | Frontrahmen |
| 18 | Stirnkante (von 18) |
| 19 | Schräge |
| 20 | Rückwand (von 1) |
| 21 | Leitblech |
| 22 | Verlängerungen (von 5) |
| 23 | Halteschiene |
| 24 | Halteschiene |
| 25 | Elektromotor |
| 26 | Lüfter |
| 27 | Leitring |
| 28 | Seitenleisten |
| 29 | Befestigungsvorrichtungen |
| 30 | Einschübe |
| 31 | Einbaugehäuse |

**Patentansprüche**

1. Einschubgehäuse für elektrische und elektronische Geräte zum Einschieben in Gestelle und Schränke eines zumindest bezüglich der Höheneinheiten genormten Aufbausystems, mit einem aus Profilschienen und Seitenwänden zusammengesetzten Baugruppenträger sowie einem mehrteiligen Mantel mit wenigstens einer Zuluftöffnung und wenigstens einer Abluftöffnung, **dadurch gekennzeichnet,**
daß der Mantel (2) eine Höheneinheit (HE) höher ist als der mehrere Höheneinheiten (HE) hohe Baugruppenträger (1),
daß der Baugruppenträger (1) zur Bildung eines am Gehäuseboden (7) angeordneten, horizontalen, seitlich nach oben offenen Zuluftschachtes (9) einen unteren Abstand (11) vom Mantel (2) aufweist, und zur Bildung eines an der Gehäusedecke (6) angeordneten, horizontalen, seitlich nach unten offenen Abluftschachtes (10) einen oberen Abstand (13) vom Mantel (2) aufweist, wobei der untere Abstand (11) und der obere Abstand (13) zusammen eine Höheneinheit (HE) betragen,
daß der Mantel (2) wenigstens eine frontseitige Zuluftöffnung (15) trägt, an welche der Zuluftschacht (9) angeschlossen ist, und
daß die Abluftöffnung (16) im oberen Bereich der Gehäuserückwand (8) vorgesehen ist und an den Abluftschacht (10) anschließt.

2. Einschubgehäuse nach Anspruch 1, **dadurch gekennzeichnet,** daß der untere Abstand (11) und der obere Abstand (13) jeweils eine halbe Höheneinheit (HE) betragen.

3. Einschubgehäuse nach Anspruch 1, **dadurch gekennzeichnet,** daß der untere Abstand (11) ein Drittel, und der obere Abstand (13) zwei Drittel einer Höheneinheit (HE) betragen.

4. Einschubgehäuse nach den Ansprüchen 1 bis 3, **dadurch gekennzeichnet,** daß der Baugruppenträger (1) eine Rückwand (20) aufweist.

5. Einschubgehäuse nach Anspruch 4, **dadurch gekennzeichnet,** daß die Rückwand (20) an den rückwärtigen Profilschienen (4) des Baugruppenträgers (1) befestigt ist.

6. Einschubgehäuse nach den Ansprüchen 1 bis 5, **dadurch gekennzeichnet,** daß im Zuluftschacht (9) zwischen dem Gehäuseboden (7) des Mantels (2) und dem Baugruppenträger (1) ein Leitblech (21) vorgesehen ist.

7. Einschubgehäuse nach den Ansprüchen 1 bis 6, **dadurch gekennzeichnet,** daß der Zuluftschacht (9) durch den Gehäuseboden (7), die beiden Seitenwände (5) sowie die offene Unterseite des Baugruppenträgers (1) gebildet ist.

8. Einschubgehäuse nach den Ansprüchen 1 bis 7, **dadurch gekennzeichnet,** daß der Abluftschacht (10) durch die Gehäusedecke (6), die beiden Seitenwände (5) sowie die offene Oberseite des Baugruppenträgers (1) gebildet ist.

9. Einschubgehäuse nach den Ansprüchen 1 bis 8, **dadurch gekennzeichnet,** daß der Mantel (2) einen rechteckigen Frontrahmen (17) aufweist, an welchem der Baugruppenträger (1) befestigt ist.

10. Einschubgehäuse nach Anspruch 9, **dadurch gekennzeichnet,** daß die Zuluftöffnung (15) an der unteren Stirnkante (18) des Frontrahmens (17) angeordnet ist.

11. Einschubgehäuse nach den Ansprüchen 9 und 10, **dadurch gekennzeichnet,** daß die Zuluftöffnung (15) durch eine Reihe von Schlitzen gebildet ist.

12. Einschubgehäuse nach Anspruch 11, **dadurch gekennzeichnet,** daß der Frontrahmen (17) eine Schräge (19) besitzt, in der die Schlitze vorgesehen sind.

13. Einschubgehäuse nach den Ansprüchen 1 bis 12, **dadurch gekennzeichnet,** daß die Seitenwände (5) des Baugruppenträgers (1) rückwärtige Verlängerungen (22) aufweisen und der Baugruppenträger (1) zwei mit den Profilschienen (3, 4) parallele Halteschienen (23 und 24) besitzt, welche an den Verlängerungen (22) befestigt sind.

14. Einschubgehäuse nach Anspruch 13, **dadurch gekennzeichnet,** daß zwischen den Halteschienen (23 und 24) ein Lüfter (26) angeordnet ist.

15. Einschubgehäuse nach den Ansprüchen 1 bis 14, **dadurch gekennzeichnet,** daß an den Seitenwänden (5) des Baugruppenträgers (1) obere und untere Seitenleisten (28) angeformt sind, welche Besfestigungsvorrichtungen (29) tragen.

16. Einschubgehäuse nach Anspruch 15, **dadurch gekennzeichnet,** daß der Frontrahmen (17) an den Befestigungsvorrichtungen (29) befestigt ist.

**Claims**

1. Slide-in housing for electrical electronic equipment, for insertion in racks and cabinets of a modular system standardized at least with respect to the height units, with an assembly carrier composed of profile rails and side walls as well as a multipart casing with at least one inlet air opening and at least one outlet air opening, characterized in that the casing (2) is one height unit (HE) higher than the assembly carrier (1), which is itself several height units (HE) high, that the assembly carrier (1) maintains a lower gap (11) relative to the casing (2) so as to form a horizontal, laterally upwardly open air inlet shaft (9) arranged on the housing floor (7), and an upper gap (13) relative to the casing (2) to form a horizontal, laterally downwardly open air outlet shaft (10) arranged on the housing roof (6), wherein the lower gap (11) and the upper gap (13) together comprise one height unit (HU), that the casing (2) carries at least one frontal air inlet opening (15), to which the air inlet shaft (9) is connected, and that the air outlet opening (16) is provided in the upper region of the housing rear wall (8) and is connected to the air outlet shaft (10).

2. Slide-in housing according to Claim 1, characterized in that the lower gap (11) and the upper gap (13) in each case amount to one half height unit (HE).

3. Slide-in unit according to Claim 1, characterized in that the lower gap (11) is one third, and the upper gap (13) is two thirds of a height unit (HE).

4. Slide-in unit according to Claims 1 to 3, characterized in that the assembly carrier (1) has a rear wall (20).

5. Slide-in housing according to Claim 4, characterized in that the rear wall (20) is secured to the rear profile rails 4 of the assembly carrier (1).

6. Slide-in housing according to Claims 1 to 5, characterized in that a baffle plate (21) is provided in the air inlet shaft (9) between the housing floor (7) of the casing (2) and the assembly carrier (1).

7. Slide-in housing according to Claims 1 to 6, characterized in that the air inlet shaft (9) is formed by the housing floor (7), the two side walls (5), as well as the open lower side of the assembly carrier (1).

8. Slide-in housing according to Claims 1 to 7, characterized in that the air outlet shaft (10) is formed by the housing roof (6), the two side walls (5), as well as the open upper side of the assembly carrier (1).

9. Slide-in housing according to Claims 1 to 8, characterized in that the casing (2) has a rectangular front frame (17) to which the assembly carrier (1) is secured.

10. Slide-in housing according to Claim 9, characterized in that the air inlet opening (15) is arranged on the lower front edge (18) of the frame (17).

11. Slide-in housing according to Claims 9 and 10, characterized in that the air inlet opening (15) is formed by a row of slits.

12. Slide-in housing according to Claim 11, characterized in that the front frame (17) has an inclined section (19) in which the slits are provided.

13. Slide-in housing according to Claims 1 to 12, characterized in that the side walls (5) of the assembly carrier (1) have rear extensions (22) and the assembly carrier (1) has two supporting rails (23) and (24) parallel to the profile rails (3, 4), which are secured to the extensions (22).

14. Slide-in housing according to Claim 13, characterized in that a fan (26) is arranged between the supporting rails (23 and 24).

15. Slide-in housing according to Claims 1 to 14, characterized in that upper and lower side strips (28) are formed on the side walls (5) of the assembly carrier (1), which strips carry fastening devices (29).

16. Slide-in housing according to Claim 15, characterized in that the front frame (17) is secured to the fastening devices (29).

**Revendications**

1. Boîtier pour tiroir pour des appareils électriques et électroniques pour l'insertion dans des baies et des armoires d'un système modulaire standardisé au moins en ce qui concerne les unités de hauteur, comprenant un châssis équipes assemblé à partir de rails profilés et de parois latérales ainsi qu'une enveloppe en plusieurs éléments avec au moins une ouverture de prise d'air et au moins une ouverture d'évacuation d'air, **caractérisé en ce** que l'enveloppe (2) est plus haute d'une unité de hauteur (HE) que le châssis équipes (1) qui s'étend sur plusieurs unités de hauteur (HE); que le châssis équipes (1) présente, pour la formation d'un puits de prise d'air (9) horizontal et ouvert latéralement vers le haut disposé au fond (7) du boîtier, un espacement inférieur (11) par rapport à l'enveloppe (2) et, pour la formation d'un puits d'évacuation d'air (10) horizontal et ouvert latéralement vers le bas disposé dans la région du dessus (6) du boitier, un espacement supérieur (13) par rapport à l'enveloppe (2), l'espacement inférieur (11) et l'espacement supérieur (13) occupant ensemble une unité de hauteur (NE); que l'enveloppe (2) comporte au moins une ouverture de prise d'air (15) frontale à laquelle est raccordé le puits de prise d'air (9), et que l'ouverture d'évacuation d'air (16) est prévue dans la partie supérieure de la paroi arrière (8) du boîtier et raccordée au puits d'évacuation d'air (10).

2. Boîtier pour tiroir selon la revendication 1, caractérisé en ce que l'espacement inférieur (11) et l'espacement supérieur (13) sont respectivement égaux à la moitié d'une unité de hauteur (HE).

3. Boîtier pour tiroir selon la revendication 1, caractérisé en ce que l'espacement inférieur (11) est égal à un tiers, et l'espacement supérieur (13), égal à deux tiers d'une unité de hauteur (HE).

4. Boîtier pour tiroir selon l'une des revendications 1 à 3, caractérisé en ce que le châssis équipes (1) comporte une paroi arrière (20).

5. Boîtier pour tiroir selon la revendication 4, caractérisé en ce que la paroi arrière (20) est fixée sur les rails profilés postérieurs (4) du châssis équipes (1).

6. Boîtier pour tiroir selon l'une des revendications 1 à 5, caractérisé en ce que dans le puits de prise d'air (9), entre le fond de boîtier (7) de l'enveloppe (2) et le châssis équipes (1), est prévue une tôle déflectrice (21).

7. Boîtier pour tiroir selon l'une des revendications 1 à 6, caractérisé en ce que le puits de prise d'air (9) est constitué par le fond (7) du boîtier, les deux parois latérales (5) ainsi que la face inférieure ouverte du châssis équipes (1).

8. Boîtier pour tiroir selon l'une des revendications 1 à 7, caractérisé en ce que le puits d'évacuation d'air (10) est constitué par le dessus (6) du boîtier, les deux parois latérales (5) ainsi que la face supérieure ouverte du châssis équipes (1).

9. Boîtier pour tiroir selon l'une des revendications 1 à 8, caractérisé en ce que l'enveloppe (2) comporte un cadre frontal (17) rectangulaire sur lequel est fixé le châssis équipes (1).

10. Boîtier pour tiroir selon la revendication 9, caractérisé en ce que l'ouverture de prise d'air (15) est disposée sur le bord frontal inférieur (18) du cadre frontal (17).

11. Boîtier pour tiroir selon les revendications 9 et 10, caractérisé en ce que l'ouverture de prise d'air (15) est constituée par une rangée de fentes.

12. Boîtier pour tiroir selon la revendication 11, caractérisé en ce que le cadre frontal (17) comporte une surface inclinée (19) dans laquelle sont prévues les fentes.

13. Boîtier pour tiroir selon l'une des revendications 1 à 12, caractérisé en ce que les parois latérales (5) du châssis équipes (1) présentent des prolongements postérieurs (22) et que le châssis équipes (1) comporte deux rails de support (23 et 24) parallèles aux rails profilés (3, 4) et fixés sur les prolongements (22).

14. Boîtier pour tiroir selon la revendication 13, caractérisé en ce qu'entre les rails de support (23 et 24) est disposé un ventilateur (26).

15. Boîtier pour tiroir selon l'une des revendications 1 à 14, caractérisé en ce que sur les parois latérales (5) du châssis équipes (1) sont conformées des baguettes latérales supérieures et inférieures (28) qui portent des dispositifs de fixation (29).

16. Boîtier pour tiroir selon la revendication 15, caractérisé en ce que le cadre frontal (17) est monté sur les dispositifs de fixation (29).

Fig.1

1 HE

2 HE

1 HE

30

1 HE

2 HE

1 HE

1/2 HE

31

1 HE

3 HE

1 HE

1/2 HE

1 HE

2 HE

1 HE

1/2 HE

1 HE

3 HE

1 HE

1/2 HE

3 HE

2 HE

1 HE

Fig. 2